Europäisches Patentamt

European Patent Office

Office européen des brevets

(19)

(11) **EP 1 021 584 B1**

(12) **EUROPEAN PATENT SPECIFICATION**

(45) Date of publication and mention
of the grant of the patent:
**26.11.2003 Bulletin 2003/48**

(51) Int Cl.7: **C23C 14/06**, C23C 14/00,
C23C 14/54, B23C 5/10

(21) Application number: **97937764.5**

(22) Date of filing: **12.09.1997**

(86) International application number:
**PCT/IB97/01089**

(87) International publication number:
**WO 99/014391 (25.03.1999 Gazette 1999/12)**

(54) **TOOL WITH PROTECTIVE LAYER SYSTEM**

WERKZEUG MIT EINEM SCHÜTZENDEN SCHICHTSYSTEM

OUTIL POURVU D'UN SYSTEME STRATIFIE PROTECTEUR

(84) Designated Contracting States:
**AT BE CH DE DK ES FI FR GB IE IT LI NL PT SE**

(43) Date of publication of application:
**26.07.2000 Bulletin 2000/30**

(73) Proprietor: **Unaxis Balzers Aktiengesellschaft**
**9496 Balzers (LI)**

(72) Inventors:
• **BRAENDLE, Hans**
**55424 Münster-Sarmsheim (DE)**
• **SHIMA, Nobuhiko**
**Narita-shi Chiba-ken 286 (JP)**

(74) Representative: **Troesch Scheidegger Werner AG**
**Patentanwälte**
**Postfach**
**8032 Zürich (CH)**

(56) References cited:
**EP-A- 0 448 720**           **EP-A- 0 701 982**

• **PETROV I ET AL: "AVERAGE ENERGY
DEPOSITED PER ATOM: A UNIVERSAL
PARAMETER FOR DESCRIBING ION-ASSISTED
FILM GROWTH?" APPLIED PHYSICS LETTERS,
vol. 63, no. 1, 5 July 1993, pages 36-38,
XP000382556**
• **PATENT ABSTRACTS OF JAPAN vol. 096, no.
012, 26 December 1996 & JP 08 209335 A
(HITACHI TOOL ENG LTD), 13 August 1996,**

• **MUNZ W -D: "Titanium aluminum nitride films: a
new alternative to TiN coatings" PROCEEDINGS
OF THE 13TH INTERNATIONAL CONFERENCE
ON METALLURGICAL COATINGS, SAN DIEGO,
CA, USA, 7-11 APRIL 1986, vol. 4, no. 6, ISSN
0734-2101, JOURNAL OF VACUUM SCIENCE &
TECHNOLOGY A (VACUUM, SURFACES, AND
FILMS), NOV.-DEC. 1986, USA, pages 2717-2725,
XP002064735**
• **ROOS J R ET AL: "INTERRELATIONSHIP
BETWEEN PROCESSING, COATING
PROPERTIES AND FUNCTIONAL PROPERTIES
OF STEERED ARC PHYSICALLY VAPOUR
DEPOSITED (TI,AL)N AND (TI,NB)N COATINGS"
JOURNAL OF THE LESS-COMMON METALS,
vol. 93 / 194, no. 1 / 02, 1 December 1990, pages
547-556, XP000168996**
• **SHEW B -Y ET AL: "Effects of r.f. bias and
nitrogen flow rates on the reactive sputtering of
TiAlN films" THIN SOLID FILMS, vol. 1-2, no. 293,
30 January 1997, page 212-219 XP004080859**
• **ADIBI F ET AL: "EFFECTS OF HIGH-FLUX
LOW-ENERGY (20-100 EV) ION IRRADIATION
DURING DEPOSITION ON THE
MICROSTRUCTURE AND PREFERRED
ORIENTATION OF TI0.5AL0.5N ALLOYS
GROWN BY ULTRA-HIGH-VACUUM REACTIVE
MAGNETRON SPUTTERING" JOURNAL OF
APPLIED PHYSICS, vol. 73, no. 12, 15 June 1993,
pages 8580-8589, XP000381378**

- KNOTEK O ET AL: "THE STRUCTURE AND COMPOSITION OF TI-ZR-N, TI-AI-ZR-N AND TI-AI-V-N COATINGS" MATERIALS SCIENCE AND ENGINEERING A: STRUCTURAL MATERIALS: PROPERTIES, MICROSTRUCTURE & PROCESSING, vol. A105/106, 1 January 1988, pages 481-488, XP000108123

## Description

This description was first filed with an <u>Appendix A</u>, which has meanwhile been published September 18, 1997, as WO/34315.

The present invention is directed on a tool with a tool body and a wear resistant layer system, wherein the layer system comprises at least one layer of MeX, wherein

-   Me comprises titanium and aluminum,

-   X is at least one of nitrogen and of carbon

and on a method of producing a tool comprising a tool body and a wear-resistant layer system.

<u>Definition:</u>

•   The term $Q_l$ is defined as the ratio of the diffraction intensities I(200) to I(111), assigned respectively to the (200) and (111) plains in the X ray diffraction of a material using the $\theta$-2$\theta$ method. Thus, there is valid $Q_l$ = I(200)/I(111). The intensity values were measured with the following equipment and with the following settings:

| Siemens Diffractometer D500 | |
| --- | --- |
| Power | Operating voltage: 30 kV |
| | Operating current: 25 mA |
| Aperture Diaphragms | Diaphragm position I: 1° |
| | Diaphragm position II: 0.1° |
| Detector Diaphragm | Soller slit |
| Time constant | 4 s |
| 2$\vartheta$ angular speed | 0.05°/min |
| Radiation | Cu-K$\alpha$(0.15406 nm) |

When we refer to "measured according to MS" we refer to this equipment and to these settings. Thereby, all quantitative results for $Q_l$ and I throughout this application have been measured by MS.

•   We understand by "tool body" the uncoated tool.

•   We understand under "hard material" a material with which tools which are mechanically and thermally highly loaded in operation are coated for wear resistance. Preferred examples of such materials are referred to below as MeX materials.

It is well-known in the tool-protecting art to provide wear resistant layer systems which comprise at least one layer of a hard material, as defined by MeX.

From I. Petrov et al. "Average energy deposited per atom: A universal parameter for describing ion-assisted film growth?", Applied Physics Letters, Vol. 63, No. 1, 5 July 1993, pages 36 to 38, it is known to deposit $Ti_{0.5} Al_{0.5} N$ films onto amorphous $SiO_2$ substrates by UHV reactive magnetron sputtering. Thereby, the preferred orientation of the films according to diffraction intensities I as mentioned above could be changed by changing ion flux, average energy deposited per atom including substrate bias. It is further described to vary the average energy $E_d$ deposited per atom, either by varying the ion energy $E_i$ or the ratio $J_i/J_{Me}$ of the incident accelerated ion flux to the flux of deposited thermal particles.

Munz W-D "Titanium aluminum nitride films: a new alternative to TiN coatings", Proceedings of the 13th international conference on metallurgical coatings, San Diego, CA, USA, 7 - 11 April 1986, Vol. 4, No. 6, ISSN 0734-2101, Journal of Vacuum Science & Technology A (Vacuum, Surfaces, and Films), Nov. - Dec. 1986, USA, pages 2717 - 2725, teaches to coat flat test samples of stainless steel or of HSS by high rate sputtering with TiAlN.

The Patent Abstract of Japan, Vol. 096, No. 012, 26 December 1996 & JP-A08 209335 A, 13 August 1996, discloses PVD or CVD method for making a hard member coated with carbides, nitrides and carbonitrides of binary or ternary system selected from Ti, group IVa metals other than Ti, group Va metals, group VIa metals and Al. Thereby, the ratio of peak intensities of the (200) plane in the X-ray diffraction pattern and of the (111) plane is reported to be at least 1.5. The value of this ratio can be regulated by the bias voltage value. Thereby, residual stress is decreased and the critical load value of the coated hard member as well as coating adhesion is improved.

Roos J.R. et al.: "Interrelationship between processing, coating properties and functional properties of steered arc physically vapour deposited (Ti,Al)N and (Ti,Nb)N coatings", Journal of the less-common metals, Vol. 93/194, No. 1/02, 1 December 1990, pages 547 - 556, discloses the relationship between processing parameters, coating properties and functional properties of steered arc PVD deposited (Ti,Al)N and (Ti,Nb)N coatings for cutting and forming tools. The coatings revealed have a strong (111) preferential texture.

The present invention has the object of significantly improving the lifetime of such tools. This is resolved by selecting for said at least one layer a $Q_I$ value, for which there is valid

$$Q_I \geq 1$$

and wherein the tool body is made of high speed steel (HSS) or of cemented carbide, whereby said tool is not a solid carbide end mill or a solid carbide ball nose mill. Further, the value of I(200) is higher by a factor of at least 20 than the intensity average value, both noise measured according to MS.

According to the present invention it has been recognised that the $Q_I$ values as specified lead to an astonishingly high improvement of wear resistance, and thus of lifetime of a tool, if such a tool is of the kind as specified.

Up to now, application of a wear resistant layer systems of MeX hard material was done irrespective of interaction between tool body material and the mechanical and thermal load the tool is subjected to in operation. The present invention thus resides on the fact that it has been recognised that an astonishing improvement of wear resistance is realised when selectively combining the specified $Q_I$ value with the specified kind of tools, thereby realising a value of I(200) higher by a factor of at least 20 than the average noise intensity level, both measured with MS.

With respect to inventively coating cemented carbide tool bodies, it has further been recognised that a significant improvement in lifetime is reached if such cemented carbide tools are inserts, drills or gear cutting tools, as e. g. hobs or shaper cutters, whereby the improvement is especially pronounced for such inserts or drills.

The inventively reached improvement is even increased if $Q_I$ is selected to be at least 2, and an even further improvement is realised by selecting $Q_I$ to be at least 5. The largest improvements are reached if $Q_I$ is at least 10. It must be stated that $Q_I$ may increase towards infinite, if the layer material is realised with a unique crystal orientation according to a diffraction intensity I(200) at a vanishing diffraction intensity I(111). Therefore, there is not set any upper limit for $Q_I$ which is only set by practicability.

As is known to the skilled artisan, there exists a correlation between hardness of a layer and stress therein. The higher the stress, the higher the hardness.

Nevertheless, with rising stress, the adhesion to the tool body tends to diminish. For the tool according to the present invention, a high adhesion is rather more important than the highest possible hardness. Therefore, the stress in the MeX layer is advantageously selected rather at the lower end of the stress range given below.

These considerations limit in practice the $Q_I$ value exploitable.

In a preferred embodiment of the inventive tool, the MeX material of the tool is titanium aluminum nitride, titanium aluminum carbonitride or titanium aluminum boron nitride, whereby the two materials first mentioned are today preferred over titanium aluminum boron nitride.

In a further form of realisation of the inventive tool, Me of the layer material MeX may additionally comprise at least one of the elements boron, zirconium, hafnium, yttrium, silicon, tungsten, chromium, whereby, out of this group, it is preferred to use yttrium and/or silicon and/or boron. Such additional element to titanium and aluminum is introduced in the layer material, preferably with a content i, for which there is valid

$$0.05 \text{ at.\%} \leq i \leq 60 \text{ at.\%,}$$

taken Me as 100 at%.

A still further improvement in all different embodiments of the at least one MeX layer is reached by introducing an additional layer of titanium nitride between the MeX layer and the tool body with a thickness d, for which there is valid

$$0.05 \text{ } \mu m \leq d \leq 5 \text{ } \mu m.$$

In view of the general object of the present invention, which is to propose the inventive tool to be manufacturable at lowest possible costs and thus most economically, there is further proposed that the tool has only one MeX material layer and the additional layer which is deposited between the MeX layer and the tool body.

Further, the stress σ in the MeX is preferably selected to be

$$1 \text{ GPa} \leq \sigma \leq 4 \text{ GPa},$$

thereby most preferably within the range

$$1.5 \text{ GPa} \leq \sigma \leq 2.5 \text{ GPa}.$$

The content x of titanium in the Me component of the MeX layer is preferably selected to be

$$70 \text{ at \%} \geq x \geq 40 \text{ at \%},$$

thereby in a further preferred embodiment within the range

$$65 \text{ at \%} \geq x \geq 55 \text{ at \%}.$$

On the other hand, the content y of aluminum in the Me component of the MeX material is preferably selected to be

$$30 \text{ at \%} \leq y \leq 60 \text{ at \%},$$

in a further preferred embodiment even to be

$$35 \text{ at \%} \leq y \leq 45 \text{ at \%}.$$

In a still further preferred embodiment, both these ranges, i.e. with respect to titanium and with respect to aluminum are fulfilled.

The deposition, especially of the MeX layer, may be done by any known vacuum deposition technique, especially by a reactive PVD coating technique, as e.g. reactive cathodic arc evaporation or reactive sputtering. By appropriately controlling the process parameters, which influence the growth of the coating, the inventively exploited $Q_l$ range is realised.

To achieve excellent and reproducible adhesion of the layers to the tool body a plasma etching technology was used, as a preparatory step, based on an Argon plasma as described in the WO/34315 with respect to such etching and subsequent coating. This document accords with the US-A-5 709 784 of the same inventor (two inventors!) and applicant as the present application.

Examples 1

An arc ion plating apparatus using magnetically controlled arc sources as described in Appendix A was used operated as shown in table 1 to deposit the MeX layer as also stated in table 1 on cemented carbide inserts. The thickness of the MeX layer deposited was always 5 μm. Thereby, in the samples Nr. 1 to 7, the inventively stated $Q_l$ values where realised, whereas, for comparison, in the samples number 8 to 12 this condition was not fulfilled. The I (200) value was always significantly larger than 20 times the noise average value, measured according to MS. The coated inserts were used for milling under the following conditions to find the milling distance attainable up to delamination. The resulting milling distance according to the lifetime of such tools is also shown in table 1.

Test cutting conditions:

- Material being cut :     SKD 61 (HRC45)

- Cutting speed:    100 m/min

- Feed speed:    0.1 m/edge

- Depth of cut :    2 mm

The shape of the inserts coated and tested was in accordance with SEE 42 TN (G9).

It is clearly recognisable from table 1 that the inserts, coated according to the present invention, are significantly more protected against delamination than the inserts coated according to the comparison conditions.

Further, the result of sample 7 clearly shows that here the stress and thus hardness of the layer was reduced, leading to lower cutting distance than would be expected for a high $Q_l$ of 22.5, still fulfilling the stress-requirements as defined above.

(Table 1)

| Sample No. | | Coating Conditions | | | Layer | x | y | $Q_1 = I(200)/I(111)$ | Residual Stress GPa | Attainable Cutting Distance (m) (distance till delamination) | Remarks |
|---|---|---|---|---|---|---|---|---|---|---|---|
| | | Bias Voltage (-V) | N₂ pressure (mbar) | Arc Current (A) | | | | | | | |
| 1 | Present Invention | 60 | $2.0 \times 10^{-3}$ | 150 | $(Ti_xAl_y)N$ | 0.5 | 0.5 | 1.5 | 5.2 | 2.2m (2.1m) | |
| 2 | | 60 | $8.0 \times 10^{-2}$ | 150 | $(Ti_xAl_y)N$ | 0.5 | 0.5 | 6.7 | 4.8 | 2.8m (2.5m) | |
| 3 | | 40 | $2.0 \times 10^{-2}$ | 150 | $(Ti_xAl_y)N$ | 0.5 | 0.5 | 8.1 | 4.2 | 8.8m (8.5m) | face lapping |
| 4 | | 40 | $3.0 \times 10^{-3}$ | 150 | $(Ti_xAl_y)N$ | 0.4 | 0.6 | 10.2 | 3.9 | 3.9m (3.5m) | |
| 5 | | 40 | $0.5 \times 10^{-3}$ | 150 | $(Ti_xAl_y)N$ | 0.5 | 0.5 | 6.0 | 5.8 | 2.0m (1.7m) | |
| 6 | | 30 | $2.0 \times 10^{-3}$ | 150 | $(Ti_xAl_y)N$ | 0.5 | 0.5 | 15.4 | 2.5 | 4.2m (4.0m) | |
| 7 | | 20 | $2.0 \times 10^{-2}$ | 150 | $(Ti_xAl_y)N$ | 0.5 | 0.5 | 22.5 | 1.2 | 3.3m (3.3m) | |
| 8 | Comparison | 60 | $0.5 \times 10^{-3}$ | 150 | $(Ti_xAl_y)N$ | 0.5 | 0.5 | 0.8 | 6.1 | 1.0m (0.8m) | |
| 9 | | 100 | $2.0 \times 10^{-2}$ | 150 | $(Ti_xAl_y)N$ | 0.5 | 0.5 | 0.7 | 5.5 | 0.9m (0.9m) | |
| 10 | | 100 | $3.0 \times 10^{-2}$ | 150 | $(Ti_xAl_y)N$ | 0.5 | 0.5 | 0.9 | 4.8 | 0.8m (0.7m) | |
| 11 | | 150 | $2.0 \times 10^{-3}$ | 150 | $(Ti_xAl_y)N$ | 0.5 | 0.5 | 0.2 | 7.2 | 0.1m (0.1m) | |
| 12 | | 100 | $0.5 \times 10^{-3}$ | 150 | $(Ti_xAl_y)N$ | 0.4 | 0.6 | 0.1 | 6.8 | 0.2m (0.1m) | |

Examples 2:

The apparatus as used for coating according to Example 1 was also used for coating the samples Nr. 13 to 22 of table 2. The thickness of the overall coating was again 5 $\mu$m. It may be seen that in addition to the coating according to Example 1 there was applied an interlayer of titanium nitride between the MeX layer and the tool body and an outermost layer of the respective material as stated in cable 2. The condition with respect to I(200) and average noise level, measured according to MS was largely fulfilled.

It may be noted that provision of the interlayer between the MeX layer and the tool body already resulted in a further improvement. An additional improvement was realised by providing an outermost layer of one of the materials titanium carbonitride, titanium aluminum oxinitride and especially with an outermost layer of aluminum oxide. Again, it may be seen that by realising the inventively stated $Q_I$ values with respect to the comparison samples number 19 to 22, a significant improvement is realised.

The outermost layer of aluminum oxide of 0.5 $\mu$m thickness, was formed by plasma CVD.

The coated inserts of cemented carbide were tested under the same cutting conditions as those of Example 1, $Q_I$ was measured according to MS .

(Table 2)

EP 1 021 584 B1

| Sample No. | | Inter-layer (μm) | TiAl Layer | x | y | Outermost Layer | $Q_1 = I(200)/I(111)$ | Attainable Cutting Distance (m) (distance till delamination) |
|---|---|---|---|---|---|---|---|---|
| Present Invention | 13 | TiN (0.4 μm) | $(Ti_xAl_y)N$ (4.6 μm) | 0.5 | 0.5 | - | 1.5 | 4.5m (4.2) |
| | 14 | TiN (0.4 μm) | $(Ti_xAl_y)N$ (4.1 μm) | 0.5 | 0.5 | TiCN (0.5 μm) | 7.2 | 7.8 (7.6m) |
| | 15 | TiN (0.4 μm) | $(Ti_xAl_y)N$ (4.4 μm) | 0.5 | 0.5 | TiCN (0.5 μm) | 6.8 | 6.0m (5.5m) |
| | 16 | TiCN (0.4 μm) | $(Ti_xAl_y)N$ (4.1 μm) | 0.5 | 0.5 | (TiAl)NO (0.5 μm) | 5.2 | 6.2m (6.0m) |
| | 17 | TiN (0.4 μm) | $(Ti_xAl_y)N$ (4.1 μm) | 0.5 | 0.5 | $Al_2O_3$ (0.5 μm) | 12.5 | 10.1m (9.8m) |
| | 18 | TiN (0.4 μm) | $(Ti_xAl_y)N$ (4.1 μm) | 0.5 | 0.5 | $Al_2O_3$ (0.5 μm) | 7.0 | 9.8m (9.5m) |
| Comparison | 19 | TiN | $(Ti_xAl_y)N$ | 0.5 | 0.5 | - | 0.8 | 1.5m (1.2m) |
| | 20 | TiN | $(Ti_xAl_y)N$ | 0.5 | 0.5 | TiCN | 0.8 | 1.9m (1.5m) |
| | 21 | TiN | $(Ti_xAl_y)N$ | 0.5 | 0.5 | TiCN | 0.7 | 1.8m (1.5m) |
| | 22 | TiN | $(Ti_xAl_y)N$ | 0.5 | 0.5 | (TiAl)NO | 0.1 | 0.6m (0.4m) |

Example 3:

Again, cemented carbide inserts were coated with the apparatus of Example 1 with the MeX layer as stated in table 3, still fulfilling the $Q_I$ conditions as inventively stated and, by far, the condition of I(200) with respect to average noise level, measured according to MS. Thereby, there was introduced one of zirconium, hafnium, yttrium, silicon and chromium, with the amount as stated above, into Me.

The coated inserts were kept in an air oven at 750°C for 30 min. for oxidation. Thereafter, the resulting thickness of the oxide layer was measured. These results are also shown in table 3. For comparison, inserts coated inventively with different Me compounds of the MeX material were equally tested. It becomes evident that by adding any of the elements according to samples 23 to 32 to Me, the thickness of the resulting oxide film is significantly reduced. With respect to oxidation the best results were realised by adding silicon or yttrium.

It must be pointed out, that it is known to the skilled artisan, that for the MeX material wear resistant layers there is valid: The better the oxidation resistance and thus the thinner the resulting oxide film, the better the cutting performance.

(Table 3)

| | Sample No. | Layer Composition | w | x | y | z | Thickness of Oxide Film (μm) |
|---|---|---|---|---|---|---|---|
| Present Invention | 23 | (Ti,Al,Y$_z$)N | | 0.48 | 0.5 | 0.02 | 0.7 |
| | 24 | (Ti,Al,Cr$_z$)N | | 0.48 | 0.5 | 0.02 | 0.9 |
| | 25 | (Ti,Al,Zr$_z$)N | | 0.48 | 0.5 | 0.02 | 0.7 |
| | 26 | (Ti,Al,Y$_z$)N | | 0.25 | 0.5 | 0.25 | 0.1 |
| | 27 | (Ti,Al,Zr$_z$)N | | 0.25 | 0.5 | 0.25 | 0.5 |
| | 28 | (Ti,Al,W$_z$)N | | 0.4 | 0.5 | 0.1 | 0.8 |
| | 29 | (Ti,Al,Si$_z$)N | | 0.4 | 0.5 | 0.1 | 0.1 |
| | 30 | (Ti,Al,Si$_z$)N | | 0.48 | 0.5 | 0.02 | 0.2 |
| | 31 | (Ti,Al,Hf$_z$)N | | 0.4 | 0.5 | 0.1 | 0.9 |
| | 32 | (Ti,Al,Y,Si$_z$)N | 0.1 | 0.3 | 0.5 | 0.1 | 0.05 |
| Comparison | 33 | (Ti,Al$_y$)N | | 0.4 | 0.6 | | 1.8 |
| | 34 | (Ti,Al,Nb$_z$)N | | 0.4 | 0.5 | 0.1 | 2.5 |
| | 35 | (Ti,Al,Ta$_z$)N | | 0.4 | 0.5 | 0.1 | 3.3 |

Example 4:

An apparatus and a coating method as used for the samples of Example 1 was again used.

HSS drills with a diameter of 6 mm were coated with a 4.5 $\mu$m MeX and a TiN interlayer was provided between the MeX layer and the tool body, with a thickness of 0.1 $\mu$m. The test condition were:

| Tool | HSS twist drill, dia. 6 mm |
|---|---|
| Material | DIN 1.2080 (AISI D3) |
| Cutting parameters | $v_c$ = 35 m/min |
| | f = 0.12 mm/rev. |
| | 15 mm deep blind holes with coolant. |

(Table 4)

| | | Bias Voltage (-V) | $N_2$ Pressure (mbar) | Arc current (A) | Inter-layer | layer | x | y | z | $Q_1$ | Residual Stress (GPa) | Number of drilled holes |
|---|---|---|---|---|---|---|---|---|---|---|---|---|
| Present Invention | 36 | 40 | $3.0 \times 10^{-3}$ | 200 | TiN 0.1 μm | $(Ti,Al,)N$ | 0.6 | 0.4 | | 5.4 | 2.1 | 210 |
| | 37 | 40 | $3.0 \times 10^{-3}$ | 200 | TiN 0.1 μm | $(Ti,Al,B,)N$ | 0.58 | 0.4 | 0.02 | 3.8 | 2.3 | 190 |
| Comparison | 38 | 150 | $1.0 \times 10^{-3}$ | 200 | TiN 0.1 μm | $(Ti,Al,)N$ | 0.6 | 0.4 | | 0.03 | 4.5 | 30 |
| | 39 | 150 | $1.0 \times 10^{-3}$ | 200 | TiN 0.1 μm | $(Ti,Al,B,)N$ | 0.58 | 0.4 | 0.02 | 0.1 | 4.8 | 38 |

13

The lifetime of the tool was determined by the number of holes which could be drilled before failure of the drill.

The results of the inventively coated drills are shown as samples No. 36 and 37 in Table 4, the samples No. 38 and 39 again show comparison samples. Again, I(200) exceeded 20 times intensity average noise level by far, for samples 36, 37, as measured by MS.

Example 5:

Again, the apparatus and method as mentioned for Example 1 was used for coating HSS roughing mills with a diameter of 12 mm with a 4.5 µm MeX layer. There was provided a titanium nitride interlayer with a thickness of 0.1 µm between the MeX layer and the tool body. The test conditions were:

| Tool | HSS roughing mill, dia. 12 mm |
| --- | --- |
| | $z = 4$ |
| Material | AISI H13 (DIN 1.2344) |
| | 640 N/mm$^2$ |
| Cutting parameters | $v_c = 47.8$ m/min |
| | $f_t = 0.07$ mm |
| | $a_p = 18$ mm |
| | $a_e = 6$ mm |
| | climb milling, dry. |

The HSS roughing mill was used until an average width of flank wear of 0.2 mm was obtained.

Sample No. 40 in Table No. 5 shows the results of the inventively coated tool, sample 41 is again for comparison. Again, I(200) of sample Nr. 40 fulfilled the condition with respect to noise, as measured by MS.

(Table 5)

| | | Bias Voltage (-V) | N₂. Pressure (mbar) | Arc current (A) | Inter-layer | layer | x | y | $Q_1$ | Residual Stress (GPa) | Cutting distance (m) |
|---|---|---|---|---|---|---|---|---|---|---|---|
| Present invention | 40 | 40 | $3.0 \times 10^{-2}$ | 200 | TiN 0.1 μm | (Ti,Al,)N | 0.6 | 0.4 | 5.4 | 2.1 | 35m |
| Comparison | 41 | 150 | $1.0 \times 10^{-2}$ | 200 | TiN 0.1 μm | (Ti,Al,)N | 0.6 | 0.4 | 0.03 | 4.5 | 11m (chipping and peeling off) |

Example 6: (comparative)

Again, the apparatus and coating method according to Example 1 was used. Solid carbide end mills with a diameter of 10 mm with 6 teeth were coated with a 3.0 μm MeX layer. There was provided a titanium nitride interlayer with a thickness of 0.08 μm between the MeX and the tool body. Test conditions for the end mills were:

| Tool | Solid carbide end mill, dia. 20 mm |
|---|---|
| | z = 6 |
| Material | AISI D2 (DIN 1.2379) |
| | 60 HRC |
| Cutting parameters | $v_c$ = 20 m/min |
| | $f_t$ = 0.031 mm |
| | $a_p$ = 15 mm |
| | $a_e$ = 1 mm |
| | Climb milling, dry |

The solid carbide end mills were used until an average width of flank wear of 0.20 mm was obtained. It is to be noted that solid carbide end mills do not belong to that group of tool which is inventively coated with a hard material layer having $Q_l \geq 1$. From the result in Table 6 it may clearly be seen that for this kind of tools $Q_l > 1$ does not lead to an improvement. Again, the I(200) to noise condition, measured with MS, was fulfilled for sample No. 42, for sample No. 43 the I(111) to noise condition was fulfilled.

(Table 6)

| | | Bias Voltage (-V) | N₂ Pressure (mbar) | Arc current (A) | Inter-layer | layer | x | y | Q, | Residual Stress (GPa) | Cutting distance (m) |
|---|---|---|---|---|---|---|---|---|---|---|---|
| Present Invention | 42 | 40 | $3.0 \times 10^{-3}$ | 200 | TiN 0.08 µm | $(Ti_xAl_y)N$ | 0.6 | 0.4 | 5.0 | 2.2 | 17m |
| Comparison | 43 | 150 | $1.0 \times 10^{-2}$ | 200 | TiN 0.08 µm | $(Ti_xAl_y)N$ | 0.6 | 0.4 | 0.05 | 4.7 | 32m |

Example 7:

Again, an apparatus and method as used for the samples of Example 1 were used.

Solid carbide drills with a diameter of 11.8 mm were coated with a 4.5 μm MeX layer. There was provided a TiN interlayer between the MeX layer and the tool body.

| Test conditions: | |
|---|---|
| Tool | Solid carbide drill, diam. 11.8 mm |
| Workpiece | Cast iron GG25 |
| Machining conditions | $v_c$ = 110 m/min |
| | f = 0.4 mm/rev. |
| | Blind hole 3 x diam. |
| | No coolant |

The solid carbide drills were used until a maximum width of flank wear of 0.8 mm was obtained. The I(200) to noise condition was again fulfilled, measured with MS.

Example 7:

EP 1 021 584 B1

(Table 7)

| | Bias Voltage (-V) | N₂ Pressure (mbar) | Arc current (A) | Inter-layer | layer | x | y | O₂ | Residual Stress (GPa) | Drilling distance (m) |
|---|---|---|---|---|---|---|---|---|---|---|
| Present Invention | 40 | $3.0 \times 10^{-3}$ | 200 | TiN 0.1 μm | $(Ti_xAl_y)N$ | 0.6 | 0.4 | 5.4 | 2.1 | 95m |
| 44 | | | | | | | | | | |
| Comparison | 150 | $1.0 \times 10^{-3}$ | 200 | TiN 0.1 μm | $(Ti_xAl_y)N$ | 0.6 | 0.4 | 0.03 | 4.5 | 48.5m |
| 45 | | | | | | | | | | |

19

Example 8:

Again, the apparatus and method as stated in Example 1 were used.

Cemented carbide inserts for turning with a shape in accordance with CNGP432 were coated with a 4.8 $\mu$m MeX layer. There was provided a TiN interlayer with a thickness of 0.12 $\mu$m between the MeX layer and the tool body. The test conditions were:

| Tool | Carbide insert (CNGP432) |
|---|---|
| Material | DIN 1.4306(X2CrNi 1911). |
| Cutting parameters | $v_c$ = 244 m/min |
| | f = 0.22 mm/rev. |
| | $a_p$ = 1.5 mm |
| | with emulsion |

The tool life was evaluated in minutes. The indicated value is an average of three measurements. Again, I (200)/noise condition, measured with MS, was fulfilled.

(Table 8)

| | | Bias Voltage (-V) | N₂ Pressure (mbar) | Arc current (A) | Inter-layer | layer | x | Y | Q₁ | Residual Stress (GPa) | Tool life (min) |
|---|---|---|---|---|---|---|---|---|---|---|---|
| Present Invention | 46 | 40 | $3.0 \times 10^{-3}$ | 200 | TiN 0.12 μm | $(Ti_xAl_y)N$ | 0.6 | 0.4 | 5.0 | 1.9 | 18.1 min |
| Comparison | 47 | 150 | $1.0 \times 10^{-3}$ | 200 | TiN 0.12 μm | $(Ti_xAl_y)N$ | 0.6 | 0.4 | 0.04 | 4.9 | 5.5 min |

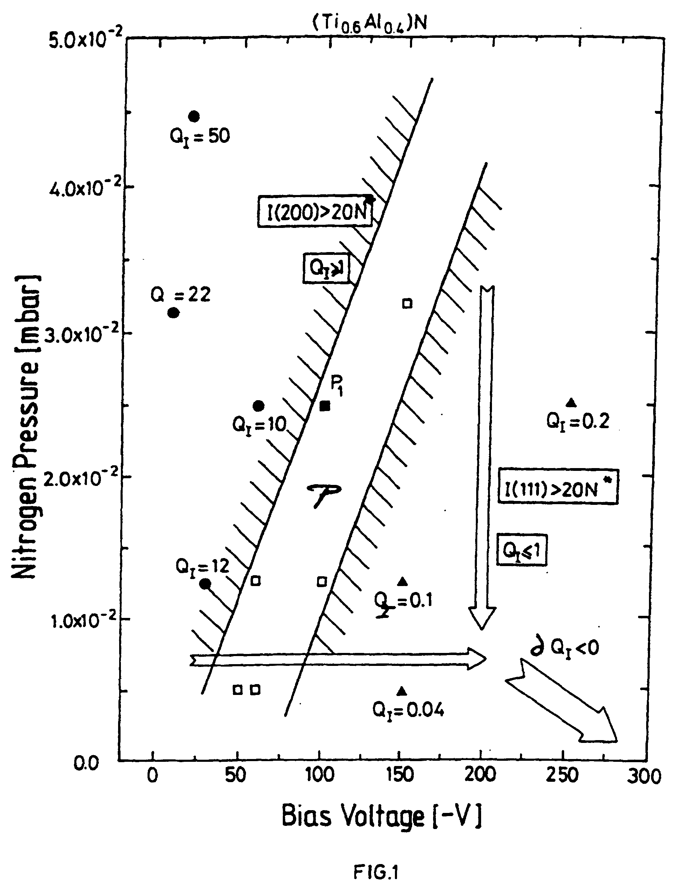

In Fig. 1 there is shown, with linear scaling a diagram of nitrogen partial pressure versus bias voltage of the tool body as applied for reactive cathodic arc evaporation as the reactive PVD deposition method used to realise the Examples which were discussed above.

All the process parameters of the cathodic arc evaporation process, namely

- arc current;

- process temperature;

- deposition rate;

- evaporated material;

- strength and configuration of magnetic field adjacent the arc source;

- geometry and dimensions of the process chamber and of the workpiece tool to be treated

were kept constant. The remaining process parameters, namely partial pressure of the reactive gas - or total pressure - and bias voltage of the tool body to be coated as a workpiece and with respect to a predetermined electrical reference potential, as to the ground potential of the chamber wall, were varied.

Thereby, titanium aluminum nitride was deposited. With respect to reactive gas partial pressure and bias voltage of the tool body, different working points were established and the resulting $Q_I$ values at the deposited hard material layers were measured according to MS.

It turned out that there exists in the diagram according to fig. 1 an area P, which extends in a first approximation linearly from at least adjacent the origin of the diagram coordinates, wherein the resulting layer leads to very low XRD intensity values of I(200) and I(111). It is clear that for exactly determining the limits of P, a high number of measurements will have to be done. Therein, none of the I(200) and I(111) intensity values is as large as 20 times the average noise level, measured according to MS.

On one side of this area P and as shown in fig. 1 $Q_I$ is larger than 1, in the other area with respect to P, $Q_I$ is lower than 1. In both these areas at least one of the values I(200), I(111) is larger than 20 times the average noise level, measured according to MS.

As shown with the arrows in fig. 1, diminishing of the partial pressure of the reactive gas - or of the total pressure if it is practically equal to the said partial pressure - and/or increasing of the bias voltage of the tool body being coated, leads to reduction of $Q_I$. Thus, the inventive method for producing a tool which comprises a tool body and a wear resistant layer system, which latter comprises at least one hard material layer, comprises the steps of reactive PVD depositing the at least one hard material layer in a vacuum chamber, thereby pre-selecting process parameter values for the PVD deposition process step beside of either or both of the two process parameters, namely of partial pressure of the reactive gas and of bias voltage of the tool body. It is one of these two parameters or both which are then adjusted for realising the desired $Q_I$ values, thus, and according to the present invention, bias voltage is reduced and/or partial reactive gas pressure is increased to get $Q_I$ values, which are, as explained above, at least larger than 1, preferably at least larger than 2 or even 5 and even better of 10. Beside the inventively exploited $Q_I$ value, in this "left hand" area, with respect to P, I(200) is larger, mostly much larger than 20 times the average noise level of intensity, measured according to MS.

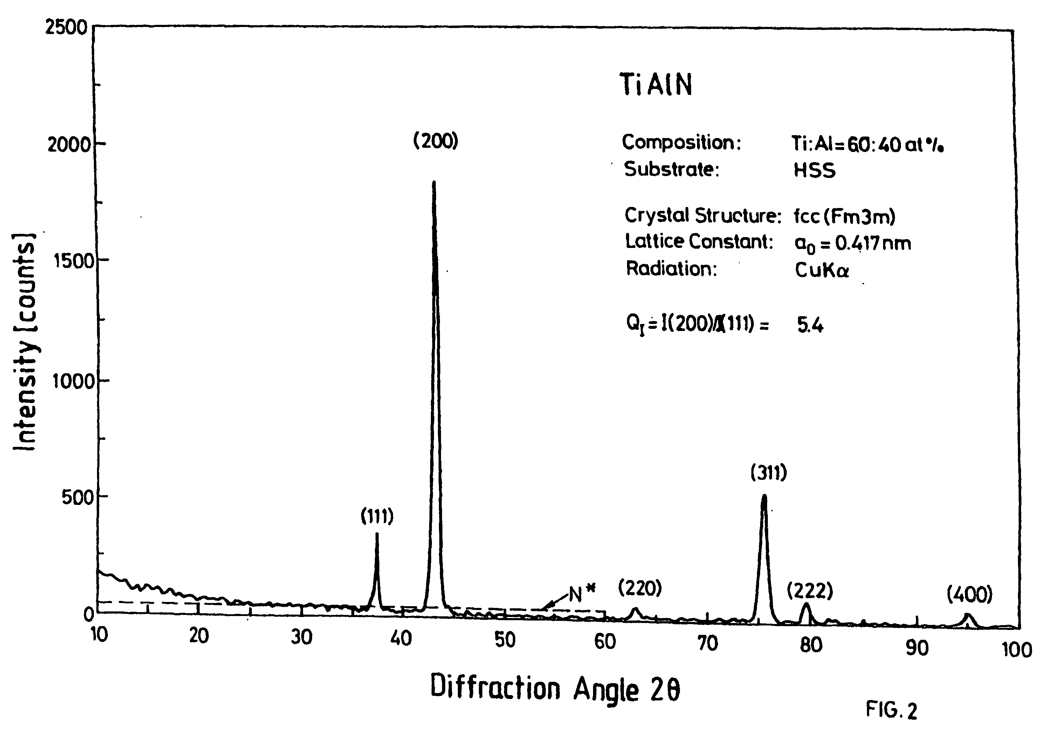

In fig. 2 a typical intensity versus angle 2θ diagram is shown for the titanium aluminum nitride hard material layer deposited in the $Q_I \geq I$ region according to the present invention of fig. 1, resulting in a $Q_I$ value of 5.4 . The average noise level N* is much less than I(200)/20. Measurement is done according to MS.

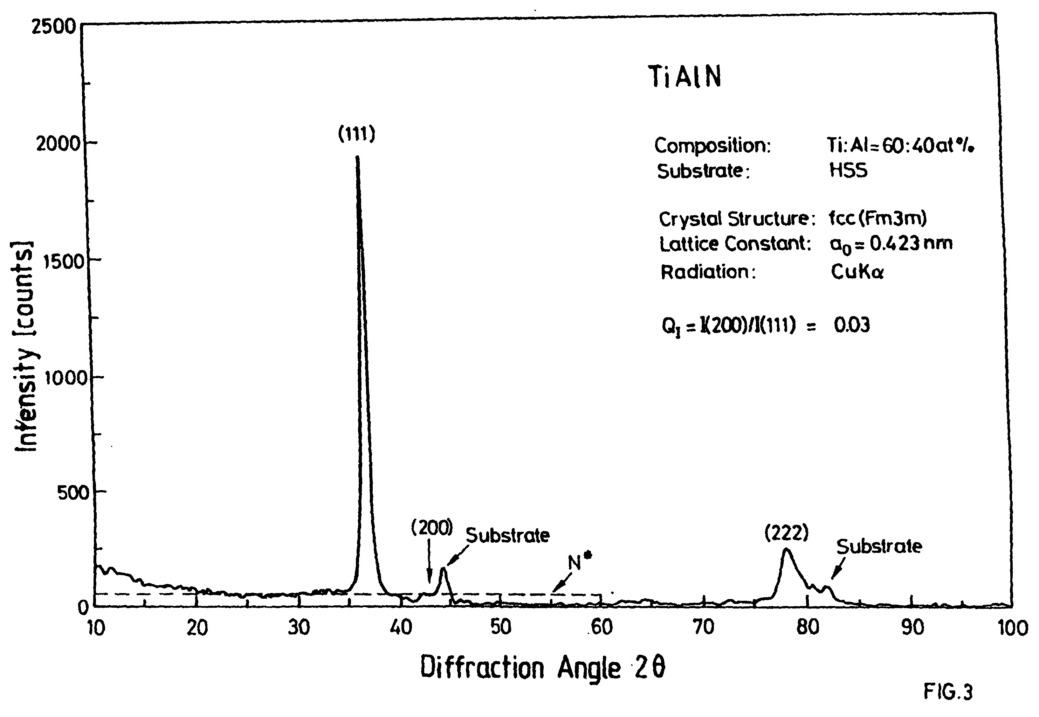

In Fig. 3 a diagram in analogy of that in fig. 2 is shown, but the titanium aluminum nitride deposition being controlled by bias voltage and nitrogen partial pressure to result in a $Q_I \leq 1$. The resulting $Q_I$ value is 0.03. Here the I(111) value is larger than the average noise level of intensity, measured according to MS.

Please note that in fig. 1 the respective $Q_I$ values in the respective regions are noted at each working point measured (according to MS)

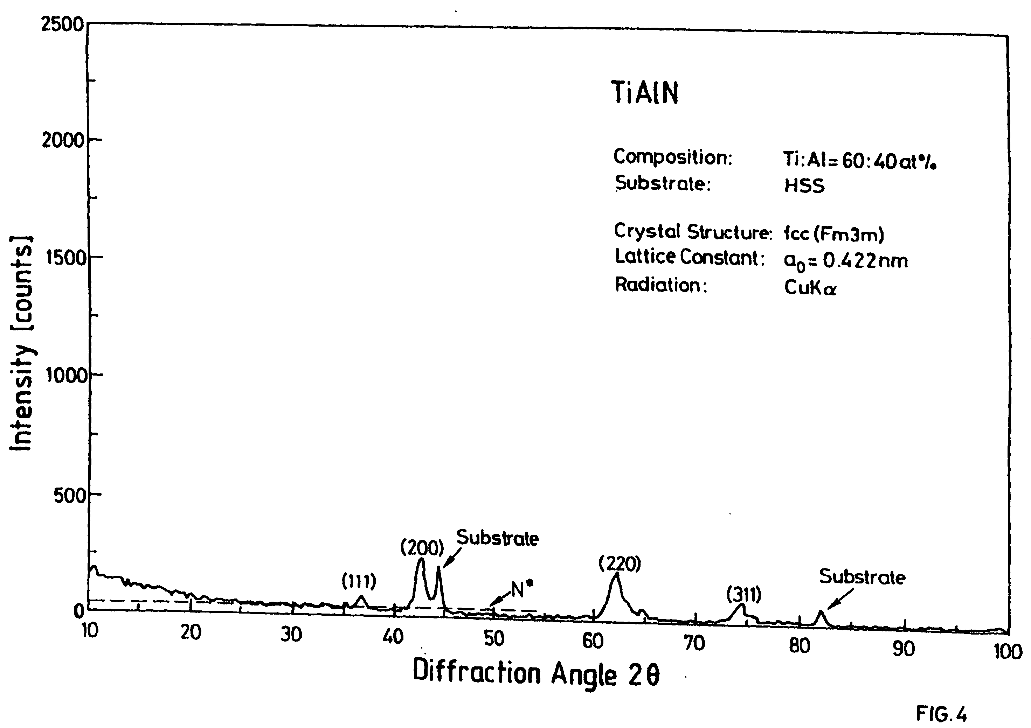

In fig. 4 a diagram in analogy to that of the figs. 2 and 3 is shown for working point $P_1$ of fig. 1. It may be seen that the intensities I(200) and I(111) are significantly reduced compared with those in the area outside P. None of the values I(200) and I(111) reaches the value of 20 times the noise average level N*.

Thus, by simply adjusting at least one of the two $Q_I$-controlling reactive PVD process parameters, namely of reactive gas partial pressure and of workpiece bias voltage, the inventively exploited $Q_I$ value is controlled.

In fig. 1 there is generically shown with $\partial Q_I < 0$ the adjusting direction for lowering $Q_I$, and it is obvious that in opposite direction of adjusting the two controlling process parameters, and increase of $Q_I$ is reached.

**Claims**

1. A tool with a tool body and a wear resistant layer system, said layer system comprising at least one layer of MeX, wherein

   - Me comprises titanium and aluminum;

   - X is at least one of nitrogen and of carbon

   and wherein said layer has a $Q_I$ value

   $$Q_I \geq 1 \;;$$

   wherein

   $$Q_I = \frac{I(200)}{I(111)}$$

   and said tool body is of one of the materials

   - high speed steel (HSS);

   - cemented carbide,

   and wherein said tool is not a solid carbide end mill and not a solid carbide ball nose mill

   - whereby the value of I(200) is at least 20 times the intensity average noise value, both measured with following equipment and settings:

   | Siemens Diffractometer D500 | |
   |---|---|
   | Power | Operating voltage: 30 kV Operating current: 25 mA |
   | Aperture Diaphragms | Diaphragm position I: 1° Diaphragm position II: 0.1° |
   | Detector Diaphragm | Soller slit |
   | Time constant | 4 s |
   | $2\vartheta$ angular speed | 0.05°/min |
   | Radiation | Cu-K$\alpha$(0.15406 nm) |

2. The tool of claim 1 being one of a cemented carbide insert, a cemented carbide drill and a cemented carbide gear cutting tool, preferably a cemented carbide insert or a cemented carbide drill.

3. The tool of claim 1 or 2, wherein there is valid for said $Q_I$:

   $$Q_I \geq 2,$$

   thereby preferably

   $$Q_I \geq 5,$$

   especially preferred

$$Q_I \geq 10.$$

4. The tool of one of claims 1 to 3, wherein said MeX material is one of titanium aluminum nitride, titanium aluminum carbonitride, titanium aluminum boron nitride, thereby preferably one of titanium aluminum nitride and titanium aluminum carbonitride.

5. The tool of one claims 1 to 4, wherein Me further comprises at least one further element out of the group consisting of boron, zirconium, hafnium, yttrium, silicon, tungsten, chromium, thereby preferably of at least one of yttrium and silicon and boron.

6. The tool of claim 5, wherein said further element is contained in Me with a content i

$$0.05 \text{ at.\%} \leq i \leq 60 \text{ at.\%},$$

taken Me as 100 at.%.

7. The tool of one of the claims 1 to 6, further comprising a further layer of titanium nitride between said at least one layer and said tool body and wherein said further layer has a thickness d, for which there is valid

$$0.05 \text{ } \mu m \leq d \leq 5.0 \text{ } \mu m.$$

8. The tool of claim 7, wherein said layer system is formed by said at least one layer and said further layer.

9. The tool of one of the claims 1 to 8, wherein the stress within said at least one layer, $\sigma$, is

$$1 \text{ GPa} \leq \sigma \leq 6 \text{ GPa},$$

thereby preferably

$$1 \text{ GPa} \leq \sigma \leq 4 \text{ GPa},$$

and even more preferred

$$1.5 \text{ GPa} \leq \sigma \leq 2.5 \text{ GPa}.$$

10. The tool of one of the claims 1 to 9, wherein the content x of titanium in Me is:

$$70 \text{ at.\%} \geq x \geq 40 \text{ at.\%},$$

preferably

$$65 \text{ at.\%} \geq x \geq 55 \text{ at.\%}.$$

11. The tool of one of the claims 1 to 10, wherein the content y of aluminum in said Me is:

$$30 \text{ at.\%} \leq y \leq 60 \text{ at.\%},$$

thereby preferably

# EP 1 021 584 B1

$$35 \text{ at.\%} \leq y \leq 45 \text{ at.\%}.$$

12. A method of producing a tool comprising a tool body and a wear resistant layer system, which comprises at least one hard material layer, comprising the steps of

- depositing said at least one layer in a vacuum chamber by means of reactive cathodic arc evaporation;

- selecting predetermined process parameter values for said reactive cathodic arc evaporation besides of at least one of the two parameters consisting of partial pressure of a reactive gas in said vacuum chamber and of bias voltage of the tool body with respect to a predetermined reference potential;

- realising said layer with a desired $Q_I$ value and a value of at least one of the I(200) and I(111) to be at least twenty times larger than the average intensity noise value, both measured with the following equipment and settings:

| Siemens Diffractometer D500 | |
| --- | --- |
| Power | Operating voltage: 30 kV |
| | Operating current: 25 mA |
| Aperture Diaphragms | Diaphragm position I: 1° |
| | Diaphragm position II: 0.1° |
| Detector Diaphragm | Soller slit |
| Time constant | 4 s |
| $2\vartheta$ angular speed | 0.05°/min |
| Radiation | Cu-K$\alpha$(0.15406 nm) |

by at least one of reducing said partial pressure for reducing said $Q_I$ value and vice versa and of increasing said bias voltage for reducing said $Q_I$ value and vice versa wherein $Q_I = \frac{I(200)}{I(111)}$

13. The method of claim 12, further comprising the step of magnetically controlling said arc evaporation.

14. The method of claim 12 or 13, further comprising the step of depositing on said tool body a MeX layer, wherein Me comprises titanium and aluminum and X is at least one of nitrogen and of carbon and is introduced to said reactive cathode arc evaporation with reactive gas.

15. The method of one of claims 12 to 14, wherein said tool body is of one of the materials

- high speed steel (HSS)

- cemented carbide

and wherein said tool is not a solid carbide end mill and not a solid carbide ball nose mill thereby selecting said $Q_I$ value to be

$$Q_I \geq 1.$$

16. The method of claim 15, thereby selecting said $Q_I$ value to be

$$Q_I \geq 2,$$

preferably to be $Q_I \geq 5$.

17. The method of claim 16, thereby selecting said $Q_I$ value to be

$$Q_I \geq 10.$$

**Patentansprüche**

1. Werkzeug mit einem Werkzeugkörper und einem verschleißfesten Schichtsystem, wobei das Schichtsystem mindestens eine Schicht aus MeX aufweist, wobei:

   - Me Titan und Aluminium beinhaltet;
   - X mindestens eines von Stickstoff und Kohlenstoff ist;

   und wobei die Schicht einen $Q_I$-Wert aufweist von

   $$Q_I \geq 1 ;$$

   wobei

   $$Q_I = \frac{I(200)}{I(111)}$$

   ist
   und der Werkzeugkörper aus einem der folgenden Materialien gebildet ist:

   - Schnellarbeitsstahl (HSS);
   - Hartmetall,

   und das Werkzeug kein Vollhartmetall-Schaftfräser und kein Vollhartmetall-Kugelkopffräser ist.

   - wobei der Wert von I(200) mindestens dem 20-fachen des durchschnittlichen Rauschintensitätswertes entspricht, und beide mit der folgenden Ausrüstung und unter folgenden Festlegungen gemessen werden:

| Siemens-Diffraktometer D 500 | |
|---|---|
| Leistung | Betriebsspannung: 30 kV |
| | Betriebsstrom: 25 mA |
| Öffnungsdiaphragmas | Blendenposition I: 1° |
| | Blendenposition II: 0,1° |
| Detektordiaphragma | Soller-Schlitz |
| Zeitkonstante | 4 s |
| Winkelgeschwindigkeit 2 θ | 0,05°/min |
| Strahlung | Cu-K$\alpha$ (0,15406 nm) |

2. Werkzeug nach Anspruch 1, welches eines von folgenden ist: ein Hartmetalleinsatz, ein Hartmetallbohrer und ein Hartmetall-Zahnradfräswerkzeug, vorzugsweise ein Hartmetalleinsatz oder ein Hartmetallbohrer.

3. Werkzeug nach Anspruch 1 oder 2, bei welchem für $Q_I$ gilt:

   $$Q_I \geq 2,$$

   bevorzugt:

   $$Q_I \geq 5,$$

besonders bevorzugt:

$$Q_l \geq 10.$$

**4.** Werkzeug nach einem der Ansprüche 1 bis 3, bei welchem das MeX-Material eines von Titan-Aluminiumnitrid, Titan-Aluminium-Carbonitrid, Titan-Aluminium-Bomitrid und bevorzugt eines von Titan-Aluminiumnitrid und Titan-Aluminium-Carbonitrid ist.

**5.** Werkzeug nach einem der Ansprüche 1 bis 4, bei welchem Me weiterhin mindestens ein weiteres Element aus einer Gruppe beinhaltet, welche Bor, Zirkonium, Hafnium, Yttrium, Silizium, Wolfram, Chrom umfasst, und von dieser bevorzugt mindestens eines von Yttrium, Silizium und Bor enthält.

**6.** Werkzeug nach Anspruch 5, bei welchem das weitere Element in Me mit einem Gehalt i enthalten ist:

$$0{,}05 \text{ at.-\%} \leq i \leq 60 \text{ at.-\%},$$

wenn Me mit 100 at.-% angenommen wird.

**7.** Werkzeug nach einem der Ansprüche 1 bis 6, welches außerdem eine weitere Schicht aus Titannitrid zwischen der mindestens einen Schicht und dem Werkzeugkörper umfasst, und bei welchem die weitere Schicht eine Dicke d aufweist, für welche gilt:

$$0{,}05 \ \mu m \leq d \leq 5{,}0 \ \mu m.$$

**8.** Werkzeug nach Anspruch 7, bei welchem das Schichtsystem durch mindestens eine Schicht und die weitere Schicht gebildet wird.

**9.** Werkzeug nach einem der Ansprüche 1 bis 8, bei welchem eine Spannung $\sigma$ innerhalb der mindestens einen Schicht beträgt:

$$1 \text{ Gpa} \leq \sigma \leq 6 \text{ GPa},$$

und davon bevorzugt,

$$1 \text{ GPa} \leq \sigma \leq 4 \text{ GPa},$$

und besonders bevorzugt

$$1{,}5 \text{ GPa} \leq \sigma \leq 2{,}5 \text{ GPa}.$$

**10.** Werkzeug nach einem der Ansprüche 1 bis 9, bei welchem der Gehalt x an Titan in Me beträgt:

$$70 \text{ at.-\%} \geq x \geq 40 \text{ at.-\%},$$

und bevorzugt

$$65 \text{ at.-\%} \geq x \geq 55 \text{ at.-\%}.$$

**11.** Werkzeug nach einem der Ansprüche 1 bis 10, bei welchem der Gehalt y an Aluminium in Me beträgt:

30 at.-% $\leq$ y $\leq$ 60 at.-%,

und davon bevorzugt,

35 at.% $\leq$ y $\leq$ 45 at.-%.

**12.** Verfahren zur Herstellung eines Werkzeuges, welches einen Werkzeugkörper und ein verschleißfestes Schichtsystem aufweist und welches mindestens eine Hartmaterialschicht besitzt, umfassend die folgenden Schritte:

- Ablagerung der mindestens einen Schicht in einer Vakuumkammer mittels reaktiver katodischer Lichtbogenbedampfung;
- Auswählen von Werten für die bevorzugten Prozessparameter für die reaktive katodische Lichtbogenbedampfung, wovon mindestens einer der beiden Parameter aus dem partiellen Druck eines reaktiven Gases in der Vakuumkammer und die Vorspannung des Werkzeugkörpers in Bezug auf ein bestimmtes Bezugspotential besteht;
- Realisieren der Schicht mit einem gewünschten $Q_l$-Wert und einem Wert, bei dem mindestens einer von I (200)und I(111) mindestens 20mal größer ist als der durchschnittliche Rauschintensitätswert, wobei beide mit der folgenden Ausrüstung und unter folgenden Festlegungen gemessen werden:

| Siemens Diffraktometer D 500 | |
|---|---|
| Leistung | Betriebsspannung: 30 kV |
| | Betriebsstrom: 25 mA |
| Öffnungsdiaphragmas | Blendenposition I: 1° |
| | Blendenposition II: 0,1° |
| Detektordiaphragma | Soller-Schlitz |
| Zeitkonstante | 4 s |
| Winkelgeschwindigkeit 2 $\theta$ | 0,05°/min |
| Strahlung | Cu-K$\alpha$ (0,15406 nm) |

durch zumindest einen von: Verminderung des Partialdruckes zur Verminderung des $Q_l$-Wertes und umgekehrt sowie Erhöhung der Vorspannung zur Verminderung des $Q_l$-Wertes und umgekehrt, wobei $Q_l = \frac{I(200)}{I(111)}$ ist.

**13.** Verfahren nach Anspruch 12, welches weiterhin den Schritt der magnetischen Steuerung der Lichtbogenbedampfung umfasst.

**14.** Verfahren nach Anspruch 12 oder 13, welches weiterhin den Schritt der Ablagerung einer MeX-Schicht auf dem Werkzeugkörper umfasst, wobei Me Titan und Aluminium umfasst und X mindestens eines von Stickstoff und Kohlenstoff ist und mit reaktivem Gas in die reaktive Katoden-Lichtbogenablagerung eingebracht wird.

**15.** Verfahren nach einem der Ansprüche 12 bis 14, bei welchem der Werkzeugkörper aus einem der Materialien gebildet ist:

- Schnellarbeitsstahl (HSS)
- Hartmetall

und bei welchem das Werkzeug kein Vollhartmetall-Schaftfräser und kein Vollhartmetall-Kugelkopffräser ist, wobei ein $Q_l$-Wert von

$Q_l \geq 1$

gewählt wird.

**16.** Verfahren nach Anspruch 15, wobei ein $Q_l$-Wert von

$$Q_l \geq 2, \text{ vorzugsweise } Q_l \geq 5$$

gewählt wird.

**17.** Verfahren nach Anspruch 16, wobei ein $Q_l$-Wert von

$$Q_l \geq 10$$

gewählt wird.

## Revendications

**1.** Outil avec un corps d'outil et un système stratifié résistant à l'usure, ledit système stratifié comprenant au moins une couche de MeX, étant précisé que

- Me contient du titane et de l'aluminium ;
- X est constitué par de l'azote et/ou du carbone

et que la couche a une valeur $Q_l$

$$Q_l \geq 1 \ ;$$

avec

$$Q_l = I(200)/I(111)$$

tandis que le corps d'outil se compose de l'une des matières suivantes :

- acier rapide (HSS) ;
- carbure fritté,

et que l'outil n'est pas une fraise à queue en carbure solide, ni une fraise à bout sphérique en carbure solide,

- la valeur I(200) étant au moins 20 fois supérieure à la valeur d'intensité de bruit moyenne, les deux étant mesurées avec l'équipement et les réglages suivants :

| diffractomètre Siemens D500 | |
|---|---|
| courant | tension de régime : 30 kV |
| | courant de régime : 25 mA |
| ouverture diaphragmes | diaphragme position I : 1° |
| | diaphragme position II : 0,1° |
| détecteur diaphragme | Soller slit |
| constante de temps | 4 s |
| vitesse angulaire 2$\vartheta$ | 0,05°/min |
| rayonnement | Cu-K$\alpha$(0,15406 nm) |

**2.** Outil selon la revendication 1, constitué par un insert en carbure fritté, un foret en carbure fritté ou une fraise à tailler les engrenages en carbure fritté, de préférence un insert en carbure fritté ou un foret en carbure fritté.

**3.** Outil selon la revendication 1 ou 2, dans lequel on a, pour $Q_l$ :

$$Q_l \geq 2,$$

de préférence

$$Q_l \geq 5,$$

plus spécialement

$$Q_l \geq 10.$$

**4.** Outil selon l'une des revendications 1 à 3, dans lequel le matériau MeX est du nitrure de titane et d'aluminium, du carbonitrure de titane et d'aluminium ou du nitrure de bore, de titane et d'aluminium, de préférence au moins un du nitrure de titane et d'aluminium ou du carbonitrure de titane et d'aluminium.

**5.** Outil selon l'une des revendications 1 à 4, dans lequel Me comporte également au moins un autre élément du groupe constitué par le bore, le zirconium, le hafnium, l'yttrium, le silicium, le tungstène, le chrome, de préférence au moins un de l'yttrium, le silicium et le bore.

**6.** Outil selon la revendication 5, dans lequel cet autre élément est contenu dans Me selon une teneur i

$$0,05 \ \%at \leq i \leq 60 \ \%at$$

si on considère que Me représente 100 %at.

**7.** Outil selon l'une des revendications 1 à 6, comportant également une autre couche de nitrure de titane entre la ou les couches et le corps d'outil, cette autre couche ayant une épaisseur d :

$$0,05 \ \mu m \leq d \leq 5,0 \ \mu m.$$

**8.** Outil selon la revendication 7, dans lequel le système stratifié est constitué par ladite ou lesdites couches et ladite autre couche.

**9.** Outil selon l'une des revendications 1 à 8, dans lequel la contrainte dans ladite ou lesdites couches, $\sigma$, est

$$1 \ GPa \leq \sigma \leq 6 \ GPa,$$

de préférence

$$1 \ GPa \leq \sigma \leq 4 \ GPa$$

et plus spécialement

$$1,5 \ GPa \leq \sigma \leq 2,5 \ GPa.$$

**10.** Outil selon l'une des revendications 1 à 9, dans lequel la teneur x en titane dans Me est :

$$70 \ \%at \geq x \geq 40 \ \%at,$$

de préférence

$$65 \text{ \%at} \geq x \geq 55 \text{ \%at.}$$

**11.** Outil selon l'une des revendications 1 à 10, dans lequel la teneur y en aluminium dans Me est :

$$30 \text{ \%at} \leq y \leq 60 \text{ \%at,}$$

de préférence

$$35 \text{ \%at} \leq y \leq 45 \text{ \%at.}$$

**12.** Méthode pour produire un outil comportant un corps d'outil et un système stratifié résistant à l'usure avec au moins une couche de matériau dur, comprenant les mesures suivantes :

- dépôt de ladite ou desdites couches dans une chambre à vide par évaporation cathodique réactive en arc ;
- sélection de valeurs de paramètre de procédé déterminées pour l'évaporation cathodique réactive en arc, en plus de l'un au moins des deux paramètres constitués par une pression partielle d'un gaz réactif dans la chambre à vide et par la tension de polarisation du corps d'outil par rapport à un potentiel de référence prédéterminé ;
- réalisation de ladite couche avec une valeur $Q_I$ souhaitée et une valeur de I(200) et/ou I(111) qui soit au moins vingt fois supérieure à la valeur d'intensité de bruit moyenne, les deux étant mesurées avec l'équipement et les réglages suivants :

| diffractomètre Siemens D 500 | |
|---|---|
| courant | tension de régime : 30 kV |
| | courant de régime : 25 mA |
| ouverture diaphragmes | diaphragme position 1 : 1° |
| | diaphragme position II : 0,1° |
| détecteur diaphragme | Soller slit |
| constante de temps | 4 s |
| vitesse angulaire 2$\vartheta$ | 0,05°/min |
| rayonnement | Cu-K$\alpha$(0,15406 nm) |

en réduisant la pression partielle pour réduire la valeur de $Q_I$ et/ou vice versa, et/ou en augmentant la tension de polarisation pour réduire la valeur de $Q_I$ et/ou vice versa, étant précisé que $Q_I$=I(200)/I(111).

**13.** Méthode selon la revendication 12, consistant également à commander par voie magnétique l'évaporation en arc.

**14.** Méthode selon la revendication 12 ou 13, consistant également à déposer sur le corps d'outil une couche de MeX, Me comportant du titane et de l'aluminium et X étant constitué par de l'azote et/ou du carbone et introduit dans l'évaporation cathodique réactive en arc avec le gaz réactif.

**15.** Méthode selon l'une des revendications 12 à 14, selon laquelle le corps d'outil est composé

- d'acier rapide (HSS) ou
- de carbure fritté

et l'outil n'est pas une fraise à queue en carbure solide, ni une fraise à bout sphérique en carbure solide, la valeur de $Q_I$ étant choisie pour que

$$Q_I \geq 1.$$

**16.** Méthode selon la revendication 15, selon laquelle la valeur de $Q_I$ est choisie pour que

$$Q_I \geq 2,$$

de préférence $Q_I \geq 5$.

**17.** Méthode selon la revendication 16, selon laquelle la valeur de $Q_I$ est choisie pour que

$$Q_I \geq 10.$$

FIG.1

**TiAlN**

| Composition: | Ti:Al = 60:40 at % |
| Substrate: | HSS |

| Crystal Structure: | fcc (Fm3m) |
| Lattice Constant: | $a_0 = 0.417$ nm |
| Radiation: | $CuK\alpha$ |

$$Q_I = I(200)/I(111) = 5.4$$

FIG. 2

EP 1 021 584 B1

TiAlN

Composition:        Ti:Al = 60:40 at%.
Substrate:          HSS

Crystal Structure:  fcc (Fm3m)
Lattice Constant:   $a_0 = 0.423$ nm
Radiation:          CuKα

$Q_1 = I(200)/I(111) = 0.03$

FIG.3

TiAlN

Composition: Ti:Al = 60:40 at%
Substrate: HSS

Crystal Structure: fcc (Fm3m)
Lattice Constant: $a_0 = 0.422$ nm
Radiation: $CuK\alpha$

FIG. 4

EP 1 021 584 B1